## Europäisches Patentamt
## European Patent Office
## Office européen des brevets

(19)

(11) Veröffentlichungsnummer : **0 129 697**
**B1**

(12) **EUROPÄISCHE PATENTSCHRIFT**

(45) Veröffentlichungstag der Patentschrift :
26.04.89

(51) Int. Cl.⁴ : **H 05 K 3/20**, H 05 K 1/16,
H 01 C 17/06

(21) Anmeldenummer : **84105615.3**

(22) Anmeldetag : **17.05.84**

(54) **Verfahren zur Herstellung von gedruckten Schaltungen.**

(30) Priorität : **22.06.83 DE 3322382**

(43) Veröffentlichungstag der Anmeldung :
**02.01.85 Patentblatt 85/01**

(45) Bekanntmachung des Hinweises auf die Patenterteilung : **26.04.89 Patentblatt 89/17**

(84) Benannte Vertragsstaaten :
**AT BE CH FR GB IT LI NL SE**

(56) Entgegenhaltungen :
EP–A– 0 073 904
DE–A– 2 118 519
FR–A– 1 142 987
FR–A– 2 489 072

(73) Patentinhaber : **Preh-Werke GmbH & Co. KG**
**Postfach 1740 An der Stadthalle**
**D-8740 Bad Neustadt/Saale (DE)**

(72) Erfinder : **Ambros, Peter, Dipl.-Chem.**
**Am Wacholderrain 12**
**D-8741 Leutershausen (DE)**
Erfinder : **Budig, Walter**
**Buchenweg 1**
**D-8741 Wülfershausen (DE)**
Erfinder : **Westermeir, Gisela, Frl.-Ing. grad.**
**Rhönblick 31**
**D-8741 Hohenroth (DE)**

EP 0 129 697 B1

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung geht von einem Verfahren zur Herstellung von gedruckten Schaltungen nach dem Oberbegriff des Anspruches 1 aus.

Gedruckte Schaltungen und ihre Abwandlungen von einfachen Druck- und Ätzplatten über flexible Schaltungen bis hin zu Vielebenen-Schaltungen sind aus der Technik unserer Zeit nicht mehr wegzudenken. Im Prinzip bestehen sie aus einer Basis- oder Trägerplatte aus einem elektrisch isolierenden Werkstoff, auf der Leiterbahnen aus einem elektrisch leitenden, metallischen Material entsprechend einem gewünschten Lay-out aufgebracht sind. Die Leiterbahnen können in verschiedenen Ebenen liegen, wobei diese durch sogenannte Durchkontaktierungen elektrisch miteinander verbunden sind. Für die Herstellung der Leiterbahnen gibt es verschiedene Verfahren. Die wichtigsten sind das Additivverfahren, das Subtraktivverfahren und das Semiadditivverfahren. Allen Verfahren ist gemeinsam, daß letztendlich die Leiterbahnen erhöht auf dem Substrat liegen. Im Falle der Anwendung der gedruckten Schaltungen z. B. für Schalter oder Potentiometer ist dies hinderlich, da der Schleifer ständig Höhenunterschiede zu bewältigen hat, so daß eine schnellere Abnutzung gegeben ist. Man ist deshalb dazu übergegangen, die Leiterbahnen und Widerstandsbahnen in das Substrat mit Hilfe der sogenannten Umkehrlaminiertechnik einzubetten.

Das Prinzip der Umkehrlaminiertechnik ist bereits aus der DE-PS 738 414 bekannt. Es wurde bei der Herstellung von Widerstandsschichten beobachtet, daß infolge der Schwerkraft sich die Leiterteilchen in der noch flüssigen Schicht vor dem Aushärten bevorzugt zum Substrat hin ablagern, während die Oberfläche an Leiterteilchen verarmt. Der spezifische Widerstand und damit die Stromverteilung ist also nicht über den ganzen Querschnitt hin gleich. Dies hat Auswirkungen auf das Rauschverhalten der Widerstandsschicht, wenn diese in einem Potentiometer eingesetzt wird. Es wurde nun angestrebt, eine Widerstandsschicht zu finden, bei der die größte Dichte der Leiterteilchen unmittelbar auf der Oberfläche auftritt und bei der die Dichte in der Richtung der Tiefe abnimmt. Hierzu wurde vorgeschlagen, die Widerstandsmasse in flüssigem Zustand zunächst auf eine behelfsmäßige Unterlage, dem Zwischenträger, aufzubringen. Unter der Einwirkung der Schwerkraft sinken die Leiterteilchen nach unten zur Seite der Unterlage hin. Nach der Aushärtung der Widerstandsmasse wird die Schicht von dem Zwischenträger abgehoben und mit der Seite, die einen geringeren Gehalt an Leiterteilchen hat, auf dem endgültigen Träger befestigt. Als Zwischenträger wird ein Körper mit einer hochglanzpolierten Oberfläche, z. B. Glas, verwendet. Von der Rauhheit dieser Oberfläche hängt auch die Oberflächenbeschaffenheit des Schichtwiderstandes ab. Dieses bekannte Verfahren wird auch dann vorgeschlagen, wenn mehrere Widerstandsschichten übereinander aufgetragen werden sollen. Mechanische Stufen entfallen bei diesem Verfahren. Bei genügend starker Schichtdicke und Absatzdauer fällt die Dichte der Leiterteilchen so stark ab, daß diese Seite als Isolator wirkt. Es ist dann möglich, als endgültiges Substrat eine Metallplatte zu nehmen, die eine günstige Wärmeleitung besitzt.

In der DE-OS 30 31 751 ist ein Umkehrlaminierverfahren beschrieben, bei dem als Zwischenträger eine metallische Folie aus einem ätzbaren Material, wie z. B. Aluminium oder Kupfer, verwendet wird. Der Zwischenträger kann auch eine Kunststoffolie sein oder sie besteht aus eloxiertem Aluminium oder aus Glas. Auch hier gilt grundsätzlich, daß die Seite des Zwischenträgers, auf der die Widerstandsmasse aufgebracht werden soll, hochglanzpoliert ist. Nach dem Auftragen der Widerstandsmasse mittels Siebdrucktechnik in dem gewünschten Lay-out erfolgt die Aushärtung. Das Übertragen der leitenden Schicht auf das endgültige Substrat erfolgt direkt oder mit Hilfe einer Klebstoffzwischenschicht. Nach dem Übertragen wird der Zwischenträger z. B. durch Ätzen oder Auflösen des Zwischenträgers in Wasser oder bei Glas durch Abheben entfernt. Um einen stufenlosen Übergang des Schleifers zu erreichen, wird der zwischen der Widerstandsschicht bzw. den dazugehörigen Leiterbahnen liegende Raum durch ein Bindemittel nach der Aushärtung der Widerstandsschicht aufgefüllt.

Ein anderes Verfahren zur Herstellung kupferkaschierter Laminate unter Zuhilfenahme der Umkehrlaminiertechnik ist aus der DE-OS 31 31 688 bekannt. Ein Aluminiumträgerblech wird mit einer als Trennmittel wirkenden Substanz beschichtet, die die Neigung hat, eine verhältnismäßig schwache Bindung mit Kupfer einzugehen. Als Substanzen werden Siliziumdioxid, Siliziumoxid oder Natron-Kalk-Fensterglas verwendet. Die Beschichtung erfolgt durch Zerstäuben, durch chemische Dampfabscheidung oder durch Elektronenstrahlverdampfungstechniken. Nach dem Beschichten des Aluminiumträgerblechs mit dieser Substanz wird durch Zerstäuben oder ein anderes Dampfabscheidungsverfahren ein Kupferüberzug aufgebracht. Anschließend wird die Kupferschicht einer elektrolytischen Behandlung unterworfen zur Bildung einer aufgerauhten Oberfläche. Nun wird diese Oberfläche galvanisch mit Zink blitzüberzogen. Der Laminierschritt erfolgt durch Pressen des so behandelten Trägerblechs mit einem Glas-Epoxyvorimprägnierten Bahnmaterial. Abschließend wird das Trägerblech durch mechanisches Abstreifen entfernt. Das Trennmittel bleibt am Trägerblech, so daß die Metalloberfläche des Laminates frei wird.

In der DE-OS-31 35 554 ist ein weiteres Verfahren zur Herstellung von gedruckten Schaltungen beschrieben, die integrierte elektrische Widerstände, Schaltkontaktstellen und die zugehörigen Leiterbahnen enthalten. Auch hier wird mit der Umkehrlaminiertechnik gearbeitet, wobei auf einem Zwischenträger die Widerstände, Schaltkontaktstellen und die Leiterbahnen im gewünschten Lay-out aufgetragen werden. Anschließend erfolgt die Aushärtung. Danach wird das Gebilde mit der beschichteten Seite auf ein Substrat unter Zuhilfenahme eines Epoxydharzklebers auflaminiert. In einem abschließenden Verfahrensschritt wird der Zwischenträger schließlich abgeätzt.

Aufgabe der vorliegenden Erfindung ist es, ein Verfahren zur Herstellung von gedruckten Schaltungen in Umkehrlaminiertechnik nach der eingangs genannten Art zu finden, bei dem der Zwischenträger sich ohne Ätzen vom Substrat leicht mechanisch lösen und damit wiederverwenden läßt.

Diese Aufgabe wird erfindungsgemäß durch die im Kennzeichnungsteil des Anspruches 1 angegebenen Verfahrensschritte gelöst.

Weitere vorteilhafte Verfahrensschritte ergeben sich aus den Unteransprüchen.

Die Erfindung wird nachfolgend anhand der Zeichnungen näher beschrieben.

Von den Figuren zeigt

Figur 1 in den verschiedenen Stadien im Verlauf der Herstellung entsprechend den Teilfiguren 1a bis 1h die Herstellung einer gedruckten Schaltung mit integrierten passiven Elementen im Umkehrlaminierverfahren,

Figur 2 mit den Teilfiguren 2a bis 2g eine andere Ausführungsform der Herstellung einer gedruckten Schaltung,

Figur 3 mit den Teilfiguren 3a bis 3g eine weitere Ausführungsform der Herstellung einer gedruckten Schaltung,

Figur 4 mit den Teilfiguren 4a bis 4f eine andere Ausführungsform der Herstellung einer gedruckten Schaltung.

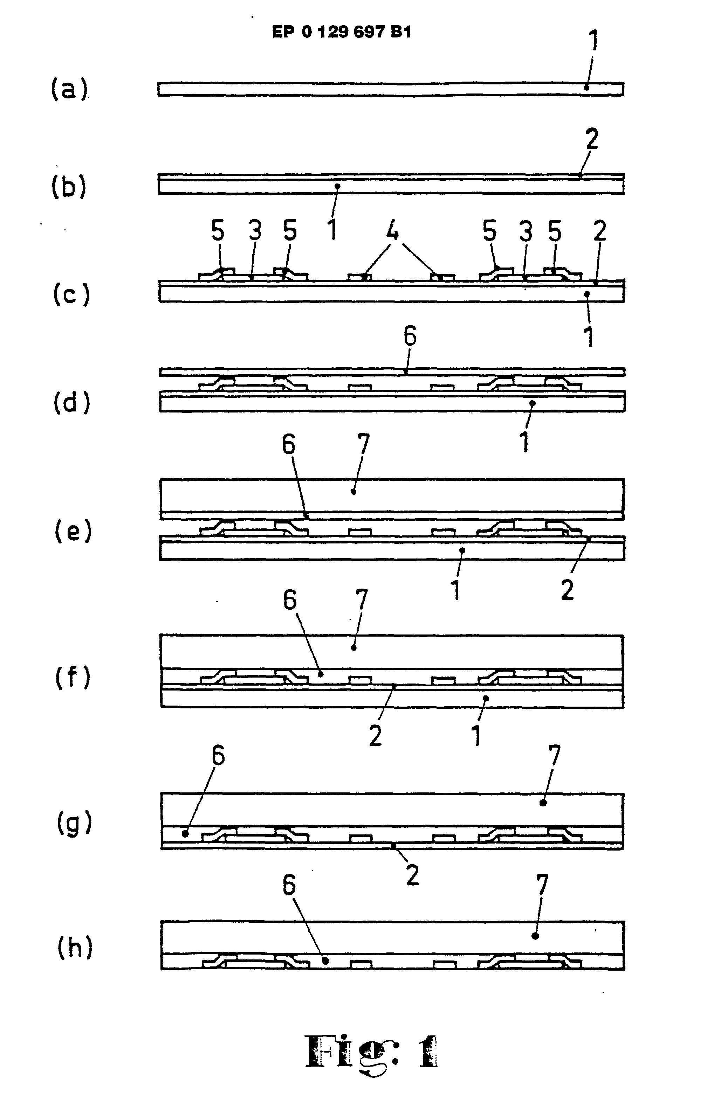

Nachfolgend wird anhand von Figur 1 eine Art der Herstellung einer gedruckten Schaltung beschrieben. Man geht zunächst von einem Zwischenträger 1 aus Metall aus. Als Metall kann man Kupfer, Zink, Eisen, Chrom, Nickel und/oder deren Legierungen verwenden. Dieser Zwischenträger muß eine hochglänzend polierte Oberfläche aufweisen. Nach dem Polieren wird er gewaschen und anschließend getrocknet. Auf der Oberfläche wird dann in einem Ofen unter Temperatureinwirkung eine dünne Metalloxidschicht als Trennschicht ausgebildet. Die Oxidschicht entsteht unter Sauerstoffeinwirkung aus dem Metall des Zwischenträgers. Von Bedeutung ist noch, daß die Oxidschicht mittels einer leicht zu handhabenden Säure, z. B. Natriumpersulfat, abätzbar ist. Als Temperatur des Ofens kann man 250° ± 10° Celsius wählen. Nach etwa einer halben Stunde hat sich eine dünne Oxidschicht 2 ausgebildet. Dieses Verhältnis Temperatur/Zeit hat sich aus wirtschaftlichen Gründen als günstig herausgestellt. Eine geringere Temperatur ginge zwar auch, aber dies würde andererseits eine längere Verweilzeit im Ofen nach sich ziehen.

Auf den mit der Oxidschicht versehenen Zwischenträger wird im Siebdruckverfahren aus einer oder ggf. auch aus mehreren Widerstandspasten geeigneter elektrischer Leitfähigkeit ein spiegelbildliches Lay-out aufgedruckt. Die Widerstandspasten bestehen üblicherweise aus einem Bindemittel, z. B. einem Melaminformaldehyd- und/oder einem Alkydharz, mit einem eindispergierten Füllstoff aus elektrisch leitenden Teilchen, die zweckmäßigerweise eine Größe < 5 μm besitzen. Als elektrisch leitende Teilchen kann man Graphit- und/oder Ruß- und/oder Silber- und/oder Nickelteilchen verwenden. Auch kann man sogenannte Pyropolymere einsetzen. Diese bestehen aus feuerfesten Teilchen, z. B. Aluminiumoxid, Siliziumoxid, Titanoxid, Eisenoxid oder deren Gemische oder Metallegierungen, die mit Kohlenstoff umhüllt sind. Unter Temperatureinwirkung werden die Widerstandsschichten ausgehärtet. Die Aushärtetemperatur und die Aushärtedauer sind weitgehend frei wählbar, so daß sie der jeweiligen Beschichtung optimal angepaßt werden können.

Gemäß Figur 1 c sind die Widerstandsschichten, die mit 3 bezeichnet sind, in den Anschlußbereichen 5 mit einer überlappenden elektrisch leitfähigen Silberpaste bedruckt. Die Widerstandsschichten können im übrigen als Festwiderstände, Potentiometerbahnen oder auch als Kontaktstellen für Tastaturen verwendet werden. Aus der gleichen Silberpaste sind zweckmäßigerweise auch die Leiterbahnen 4 hergestellt.

Wie aus Figur 1 d hervorgeht wird auf den so beschichteten Zwischenträger 1 eine Prepregfolie 6 gelegt, die aus einem mit einem Epoxidharz imprägnierten Polyester-Vließ besteht. Über diese Folie wird gemäß Figur 1 e das endgültige Substrat 7 gelegt, das aus einem Schichtpreßstoff oder einem duroplastischen Kunststoff besteht. Auch ist die Verwendung eines Metallbleches möglich. Für diesen Fall sollte die Prepregfolie dicker sein, so daß sich im fertigen Zustand zwischen dem höchsten Punkt des beschichteten Zwischenträgers und dem Substrat noch eine genügend dicke Isolierschicht befindet.

Das in Figur 1 e dargestellte Paket wird unter Temperatureinwirkung und Druck laminiert. Die Temperatur beträgt 100 bis 200 °C, vorzugsweise 120 °C. Der Druck liegt bei 1 bis 5 N/mm², vorzugsweise bei 1,5 N/mm². Die Laminierung erfolgt innerhalb einer Zeit von 20 Min. bis 3 Stunden. Bei dem Laminiervorgang füllt das erwärmte und daher fließfähige Material der Prepregfolie 6 die Zwischenräume zwischen den Widerstandsschichten und den Leiterbahnen bzw. im Bedarfsfall weiterer Erhebungen auf dem Zwischenträger aus. Das so erhaltene Gebilde ist in Figur 1 f dargestellt.

Nach dem Laminiervorgang wird der Zwischenträger 1 mechanisch abgezogen (1 g). Die noch verbleibende Oxidschicht 2 wird anschließend abgeätzt. Nach dem Abätzen der dünnen Oxidschicht kommt die endgültige Oberfläche zum Vorschein. Diese Schicht ist extrem glatt und weist keine Stufen auf, auch wenn mehrere sich überlappende Beschichtungen aufgetragen wurden. In Figur 1 c ist nur ein Beschichtungsvorgang dargestellt. Es ist selbstverständlich auch denkbar, mehrere Beschichtungen unter Zwischenschaltung von Isolierschichten aufzubringen.

3

Die frühere Oberfläche wurde durch den Umkehrlaminierprozess in das neue, nun endgültige Substrat eingesenkt. Dadurch werden die Widerstandsschichten und die Leiterbahnen fest verankert. Sie sind nicht nur von unten, sondern auch seitlich z. B. gegen Feuchteeinwirkungen geschützt.

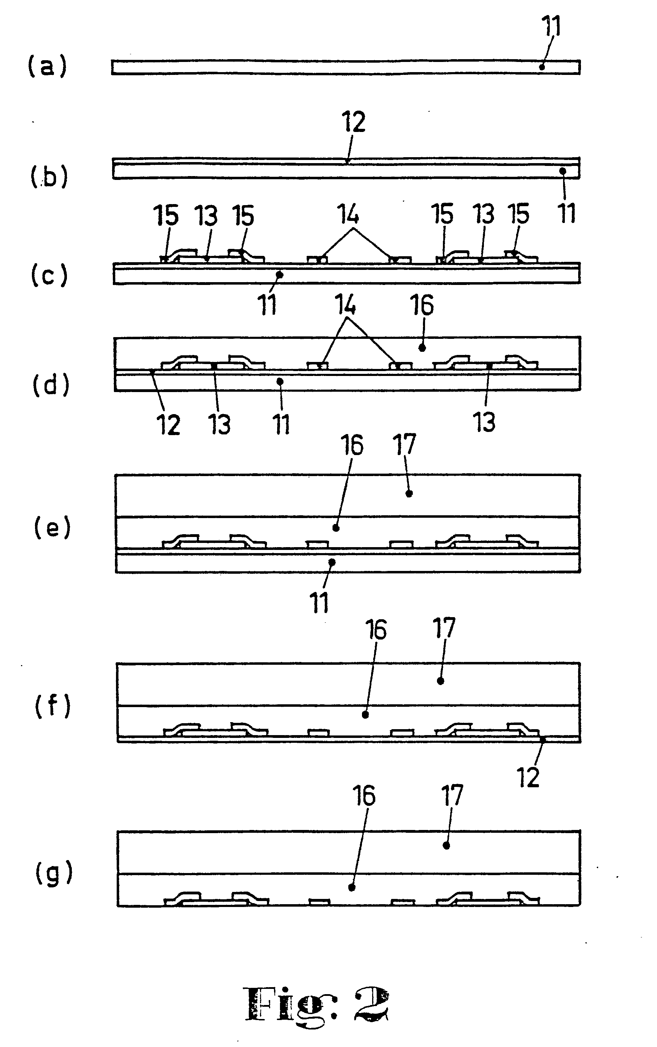

Nachfolgend wird anhand von Figur 2, deren Teilfiguren 2 a bis 2 g verschiedene Stadien im Verlauf des Herstellungsverfahrens der gedruckten Schaltung veranschaulichen, eine abgewandelte Ausführungsform der Erfindung erläutert. Die Verfahrensschritte 2 a bis 2 c entsprechen den Schritten 1 a bis 1 c der Figur 1. Mit 11 ist der Zwischenträger bezeichnet. Das Bezugszeichen 12 kennzeichnet die Metalloxidschicht. Auf den mit dem Metalloxid versehenen Zwischenträger sind vorzugsweise im Siebdruckverfahren die Widerstandsschicht 13, die Anschlußbereiche 15 und die Leiterbahnen 14 aufgebracht. Bei dem in Figur 2 d veranschaulichten Verfahrensschritt wird über den beschichteten und ausgehärteten Zwischenträger ein Laminierharz gegossen, wobei die Zwischenräume zwischen den Widerstandsschichten, den Anschlußbereichen und den Leiterbahnen ausgefüllt werden. Als Laminierharz wird vorzugsweise ein Epoxid-, Phenol-, Polyesterharz oder Mischungen hiervon verwendet. Es entsteht so nach dem Aushärten eine Zwischenschicht, die in Figur 2 mit 16 bezeichnet ist. Gemäß Figur 2 e wird über das Gebilde das endgültige Substrat gelegt und in dem bereits beschriebenen Laminiervorgang verpreßt. Die nachfolgenden Verfahrensschritte 2 f und 2 g bezüglich des Ablösens des Zwischenträgers und der Metalloxidschicht entsprechen den Schritten 1 g und 1 h der Figur 1.

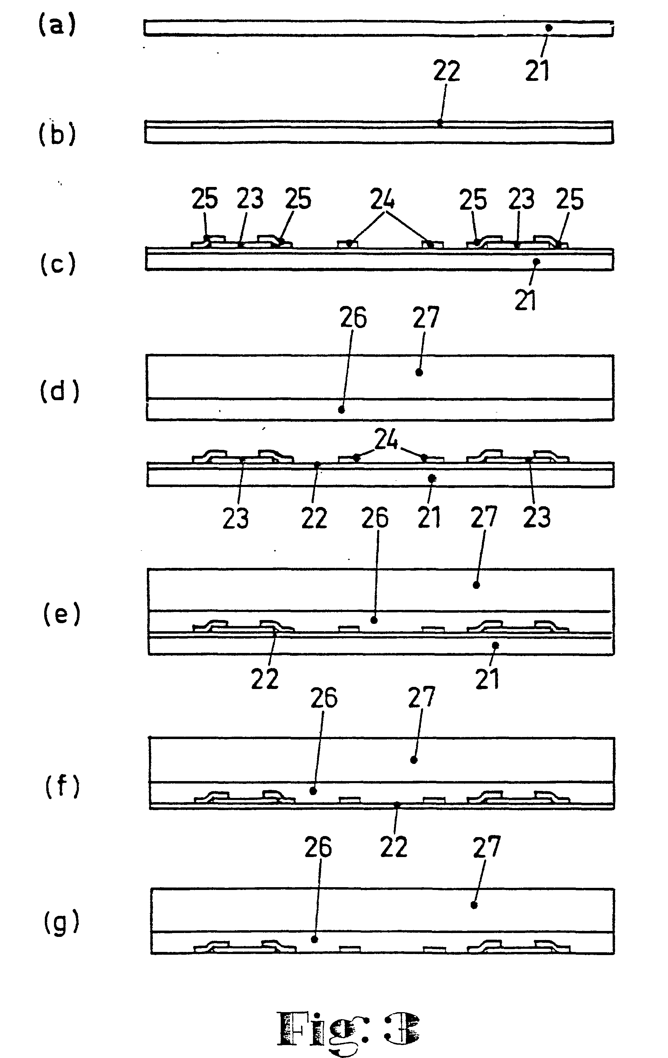

Eine weitere Abwandlung des Herstellungsverfahrens ist in Figur 3 dargestellt. Im Gegensatz zu dem Verfahren nach Figur 2 wird hier das Laminierharz nicht auf den beschichteten Zwischenträger gegossen, sondern auf das endgültige Substrat. Teilfigur 3 d veranschaulicht diesen Vorgang. Die übrigen Verfahrensschritte entsprechen den bereits beschriebenen Schritten. Auch die Bezugszeichen sind entsprechend gewählt. So bedeutet 21 den Zwischenträger und 22 die Metalloxidschicht. Die Beschichtung besteht aus der Widerstandsschicht 23, den Anschlußbereichen 25 und den Leiterbahnen 24. Die Zwischenschicht aus dem Laminierharz trägt das Bezugszeichen 26. Das endgültige Substrat ist mit 27 bezeichnet.

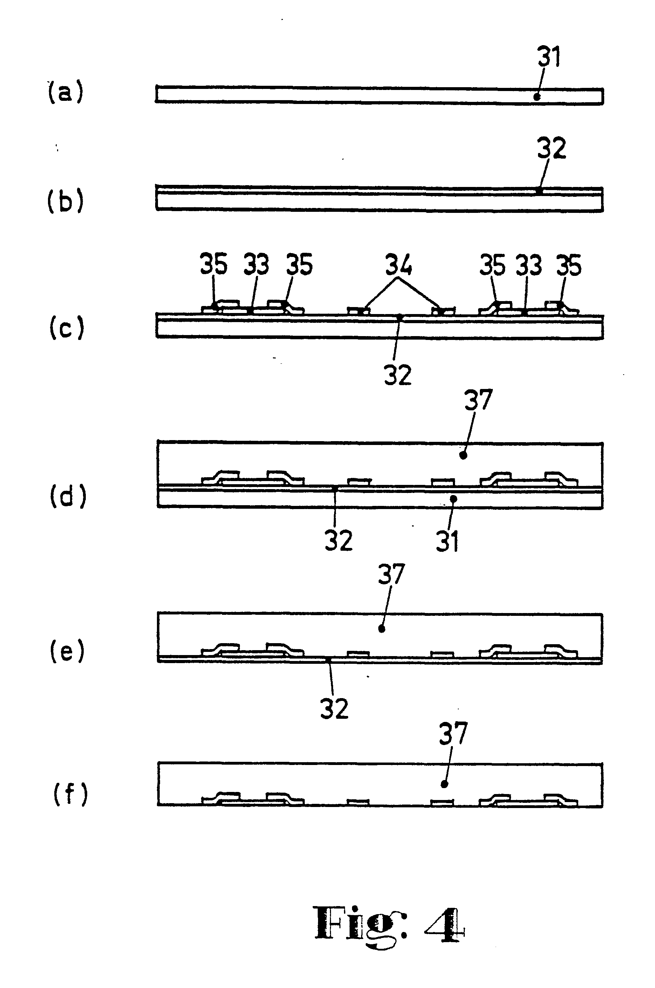

Ein weiteres Herstellungsverfahren ist in Figur 4 veranschaulicht. Die Verfahrensschritte 4 a bis 4 c entsprechen den Schritten der anderen Verfahren. Gemäß Figur 4 d wird der mit der Oxidschicht versehene, beschichtete und ausgehärtete Zwischenträger 31 von einer Zwischenschicht bedeckt, die gleichzeitig das endgültige Substrat 37 darstellt und die im Preß-, Spritzgieß- oder Spritzpreßverfahren hergestellt ist. Man nimmt hierzu als Material einen Duroplast, vorzugsweise ein Polyphenol und/oder ein Polyester. Die Entfernung des Zwischenträgers und der Metalloxidschicht gemäß Figur 4 e und 4 f wurde bereits bei den anderen Verfahren beschrieben. Auch die Bezugszeichen sind entsprechend gewählt. Mit 31 ist der Zwischenträger und mit 32 die Metalloxidschicht bezeichnet, die Beschichtung besteht aus der Widerstandsschicht 33, den Anschlußbereichen 35 und den Leiterbahnen 34. Eine eigentliche Zwischenschicht entfällt hier. Das Substrat ist mit 37 bezeichnet.

In den Figuren 1 bis 4 wurden der Einfachheit halber jeweils die gedruckten Schaltungen nur auf der einen Seite des Substrates erzeugt. Es können jedoch auch auf beiden Seiten des Substrates elektrische Schaltungen, ggf. auch in Multi-Layer-Ausführung, aufgebaut werden, wobei die Schaltungen der verschiedenen Ebenen bzw. auf den beiden Seiten des Substrates durch Durchkontaktierungen elektrisch-funktionell miteinander verbunden werden.

Die integrierten Widerstandsschichten, Potentiometerbahnen oder Schaltkontaktstellen können jeweils durch Bedruckung mit nur einer Widerstandspaste geeigneter Leitfähigkeit erzeugt werden. Verschiedene Widerstandswerte werden durch entsprechende geometrische Formgebung realisiert. Alternativ können zur Realisierung unterschiedlicher Widerstandswerte jedoch auch Bedruckungen mit unterschiedlichen Widerstandspasten verschiedener Leitfähigkeit erfolgen.

Es folgen mehrere Beispiele, die das erfindungsgemäße Verfahren und die damit erzielten Ergebnisse veranschaulichen.


Beispiel 1

Ein Zwischenträger aus Bronzeblech, 0,5 mm dick, wird in einer Polieranlage hochglänzend poliert, gewaschen und in einer Freonanlage getrocknet. Anschließend wird dieser Zwischenträger in einem Ofen bei einer Temperatur von 250 °C bei einer Dauer von einer halben Stunde mit einer dünnen Oxidschicht versehen.

In einer danach folgenden Operation wird der Zwischenträger mittels Siebdruckverfahren mit einer Siebdruckpaste im erforderlichen Layout bedruckt und bei 230 °C 1 Stunde lang ausgehärtet. Die Siebdruckpaste ist aus Melaminformaldehyd und Alkydharz als Bindemittel, mit eindispergierten feuerfesten und mit Kohlenstoff umhüllten Teilchen der Größe < 5 μm in einem Verhältnis 1 Gew.-Teil Bindemittel und 1 Gew.-Teil Füllstoff.

Eine Hartgewebeplatte der FR-4-Qualität wird gebürstet, gewaschen und bei 140 °C drei Stunden lang getrocknet und getempert.

Danach wird unter Zuhilfenahme von jeweils 2 Prepreg-Lagen, die aus mit Laminierharz der Epoxydbasis imprägnierten Polyester-Vließ aufgebaut sind, ein Presspaket zusammengesetzt, so daß folgende Anordnung entsteht :

1. Metallischer Zwischenträger mit einer zum Umlaminieren bestimmten Schicht ;
2. Prepreg-Lage
3. Hartgewebe der FR-4-Qualität
4. Prepreg-Lage

Die unter Punkt 4 angeführte Prepreg-Lage ist nur dazu bestimmt, eine Krümmung des Substrates zu verhindern.

Dieses Presspaket wird dann in einer Multilayerpresse bei 120 °C 20 Minuten lang gepresst bei einem Druck 1,5 N/mm². Anschließend wird das Presspaket getrennt, wobei auch der Zwischenträger entfernt wird. Die Schicht, z. B. Widerstandsschicht, hat sich auf den endgültigen Glashartgewebe-Träger umlaminiert. An der Widerstandsschicht-Oberfläche ist eine hauchdünne Oxidschicht zurückgeblieben, die im nächsten Schritt mit Natriumpersulfat abgeätzt wird. Danach wird das nun fertige Produkt auf die endgültige Form zugeschnitten.

## Beispiel 2

Verfahren wie im Beispiel 1, jedoch mit dem Unterschied, daß das endgültige Substrat Hartpapier der FR-3-Qualität ist, das mit einem Laminierharz der Epoxyd-Basis im B-Zustand beschichtet ist. Die Prepreg-Lage entfällt.

## Beispiel 3

Verfahren wie Beispiel 1 und 2, wobei die Seite des Zwischenträgers, die mit einer rußgefüllten Widerstandsschicht versehen ist, zusätzlich eine Schicht eines Laminierharzes der Polyphenolbasis im B-Zustand aufweist, und das endgültige Substrat ein Hartpapier der FR-2-Qualität ist.

## Beispiel 4

Ein Zwischenträger wie im Beispiel 1 wird in ein Werkzeug einer Spritzgieß-Maschine eingelegt. Die am Zwischenträger sich befindende Schicht wird mit einer Polyesterspritzgieß-Masse umspritzt, wobei diese duroplastische Kunststoffmasse das eigentliche Substrat bildet.

## Beispiel 5

Ein Zwischenträger wie im Beispiel 1 wird in ein Werkzeug einer Spritz-Pressmaschine eingelegt und mit einer Polyphenol-Masse umspritzt, wobei diese duroplastische Kunststoffmasse das eigentliche Substrat bildet.

## Beispiel 6

Ein Zwischenträger wie im Beispiel 1, 4 und 5 wird in ein Werkzeug einer Duroplast-Presse eingelegt und mit einer vorpolymerisierten Dialylphtalat-Pressmasse umpresst.

Die Verfahren nach den Beispielen 4, 5 und 6 werden vorzugsweise zur Herstellung von Produkten mit geringer Ausdehnung, wie z. B. Potentiometer, Schalter usw., eingesetzt.

Bezugszeichenliste

| Zwischenträger | 1, | 11, | 21, | 31 |
| Trennschicht | 2, | 12, | 22, | 32 |
| Widerstandsschicht | 3, | 13, | 23, | 33 |
| Leiterbahnen | 4, | 14, | 24, | 34 |
| Anschlußbereich | 5, | 15, | 25, | 35 |
| Zwischenschicht | 6, | 16, | 26 | |
| Substrat | 7, | 17, | 27, | 37 |

Beispiel 1    Beispiel 2    Beispiel 3    Beispiel 4

5

## Patentansprüche

1. Verfahren zur Herstellung von gedruckten Schaltungen nach dem Umkehrlaminierverfahren mit in diese integrierten elektrischen Widerständen, Leiterbahnen und/oder Kontaktstellen, das die nachfolgenden Verfahrensschritte aufweist

— ein temperatur-formbeständiger, metallischer, als vorläufiges Substrat dienender Zwischenträger (1, 11, 21, 31) wird auf seiner Beschichtungsseite hochglänzend poliert, gereinigt und gewaschen und anschließend getrocknet,

— der Zwischenträger (1, 11, 21, 31) wird im gewünschten spiegelbildlichen Lay-out mit der Widerstands-, der Leiterbahnen- und der Anschlußbereichsmasse mehrstufig bedruckt unter Zwischenschaltung einer Antrocknung,

— das mit dem Lay-out versehene Gebilde wird zur Aushärtung der Widerstandsmasse einer Wärmebehandlung bei einer erhöhten Temperatur unterworfen,

— das Gebilde wird mit der Beschichtungsseite unter Hinzufügung einer Zwischenschicht (6, 16, 26) auf ein als permanenter Schaltungsträger dienendes Substrat (7, 17, 27, 37) auflaminiert, dadurch gekennzeichnet,

— daß nach der Trocknung des Zwischenträgers (1, 11, 21, 31) eine Metalloxidschicht als abätzbare Trennschicht (2, 12, 22, 32) auf der Beschichtungsseite des Zwischenträgers (1, 11, 21, 31) erzeugt wird, wobei die Erzeugung aus dem Metall des Zwischenträgers (1, 11, 21, 31) unter Sauerstoff- und Temperatureinwirkung in einem Ofen erfolgt, und

— daß nach dem Auflaminieren auf den permanenten Schaltungsträger (7, 17, 27, 37) der Zwischenträger (1, 11, 21, 31) durch Abziehen entfernt wird sowie die Trennschicht (2, 12, 22, 32) von dem endgültigen Produkt weggeätzt wird.

2. Verfahren nach Anspruch 1, dadurch gekennzeichnet, daß die Trocknung des Zwischenträgers (1, 11, 21, 31) in einer Freonanlage vorgenommen wird.

3. Verfahren nach Anspruch 1, dadurch gekennzeichnet, daß die Erzeugung der Trennschicht (2, 12, 22, 32) unter Temperatureinwirkung bei 250 °C ± 10 °C in einer halben Stunde erfolgt.

4. Verfahren nach Anspruch 1, dadurch gekennzeichnet, daß die Widerstandsmasse aus einem organischen Bindemittel mit einem eindispergierten Füllstoff besteht.

5. Verfahren nach Anspruch 4, dadurch gekennzeichnet, daß das Bindemittel ein Melaminformaldehyd- und/oder Alkydharz ist.

6. Verfahren nach Anspruch 4, dadurch gekennzeichnet, daß der Füllstoff aus Graphit- und/oder Ruß- und/oder Silber- und/oder Nickelteilchen und/oder mit Kohlenstoff umhüllten, feuerfesten Teilchen mit der Größe < 5 μm besteht.

7. Verfahren nach Anspruch 1, dadurch gekennzeichnet, daß das Metall des Zwischenträgers Kupfer, Zinn, Zink, Eisen, Chrom, Nickel und/oder deren Legierungen ist.

8. Verfahren nach Anspruch 1, dadurch gekennzeichnet, daß die Zwischenschicht aus einer aus mit einem Epoxidharz imprägnierten Vließ oder Gewebe hergestellten Prepregfolie (6) besteht.

9. Verfahren nach Anspruch 1, dadurch gekennzeichnet, daß die Auflaminierung bei einer Temperatur von 100 °C bis 200 °C, vorzugsweise 120 °C, und bei einem Druck von 1 bis 5 N/mm², vorzugsweise 1,5 N/mm², innerhalb einer Zeit von 20 Min. bis 3 Stunden erfolgt.

10. Verfahren nach Anspruch 1, dadurch gekennzeichnet, daß die aus einem Laminierharz bestehende Zwischenschicht (17, 27) entweder auf dem beschichteten Zwischenträger (1, 11, 21, 31) oder auf dem Substrat (7, 17, 27, 37) oder auf beiden angebracht ist.

11. Verfahren nach Anspruch 10, dadurch gekennzeichnet, daß das Laminierharz ein Epoxid-, Phenol-, Polyesterharz oder eine Mischung hiervon ist.

12. Verfahren nach Anspruch 1, dadurch gekennzeichnet, daß das Substrat ein Isolierstoff oder ein durch die Zwischenschicht elektrisch isoliertes Metallblech ist.

13. Verfahren nach Anspruch 1, dadurch gekennzeichnet, daß die gleichzeitig das Substrat (37) darstellende Zwischenschicht im Preß-, Spritzpreß- oder Spritzgießverfahren hergestellt ist.

14. Verfahren nach Anspruch 13, dadurch gekennzeichnet, daß das Substrat (37) ein Duroplast, vorzugsweise ein Polyphenol und/oder ein Polyester ist.

## Claims

1. Process for the manufacture of printed circuits according to the reverse laminating process having electric resistances, strip conductors and/or points of contact integrated into these printed circuits, which process has the following procedural steps :

— a metallic intermediate member (1, 11, 21, 31), the shape of which is temperature-constant, serving as a temporary substrate is, on its coating side, highly polished, cleaned, washed and subsequently dried,

— the intermediate member (1, 11, 21, 31) is printed on, in a multistage manner, in the desired reflected lay-out with the resistance material, the strip conductor material and the connection range material during the interposition of a surface drying,

— the structure provided with the lay-out is submitted to a heat treatment at an increased

6

temperature in order to solidify the resistance material,
— with the addition of an intermediate layer (6, 16, 26), the structure is laminated with the coating side on to a substrate (7, 17, 27, 37) serving as permanent circuit member,
characterized in that
— after the drying of the intermediate member (1, 11, 21, 31) a metallic oxide layer is produced on the coating side of the intermediate member (1, 11, 21, 31) as separation layer (2, 12, 22, 32) which can be etched, the production occurring in an oven from the metal of the intermediate member (1, 11, 21, 31) under the influence of oxygen and temperature, and in that
— after the laminating on the permanent circuit member (7, 17, 27, 37), the intermediate member (1, 11, 21, 31) is removed by being pulled off just as the separation layer (2, 12, 22, 32) is etched away from the final product.

2. Process according to claim 1, characterized in that the drying of the intermediate member (1, 11, 21, 31) is undertaken in a freon installation.

3. Process according to claim 1, characterized in that the production of the separation layer (2, 12, 22, 32) occurs in half an hour under the influence of a temperature at 250 °C ± 10 °C.

4. Process according to claim 1, characterized in that the resistance material consists of an organic bonding agent with a filler dispersed therein.

5. Process according to claim 4, characterized in that the bonding agent is a melamine formaldehyde resin and/or alkyd resin.

6. Process according to claim 4, characterized in that the filler consists of particles of graphite and/or soot and/or silver and/or nickel and/or fireproof particles, enclosed in carbon, of the size < 5 μm.

7. Process according to claim 1, characterized in that the metal of the intermediate member is copper, tin, zinc, iron, chrome, nickel and/or their alloys.

8. Process according to claim 1, characterized in that the intermediate layer consists of a prepreg film (6) produced from fleece or woven textile which is impregnated with an epoxide resin.

9. Process according to claim 1, characterized in that the laminating occurs at a temperature of 100 °C to 200 °C, preferably 120 °C and at a pressure of 1 to 5 N/mm$^2$, preferably 1.5 N/mm$^2$, within a duration of 20 minutes to 3 hours.

10. Process according to claim 1, characterized in that the intermediate layer (17, 27) consisting of a laminate resin is attached either on to the coated intermediate member (1, 11, 21, 31) or on to the substrate (7, 17, 27, 37) or on to both.

11. Process according to claim 10, characterized in that the laminate resin is an epoxide resin, phenolic resin, polyester resin or a mixture thereof.

12. Process according to claim 1, characterized in that the substrate is an insulating material or a metal sheet electrically insulated by the intermediate layer.

13. Process according to claim 1, characterized in that the intermediate layer, representing the substrate (37) at the same time, is produced in a pressing process, spray-pressing process or injecting process.

14. Process according to claim 13, characterized in that the substrate (37) is a duroplastic, preferably a polyphenol and/or a polyester.


**Revendications**

1. Procédé pour fabriquer des circuits imprimés selon le procédé de stratification inverse, comportant des résistances électriques, des pistes conductrices et/ou des zones de contact qui y sont intégrées, ce procédé présentant les étapes opératoires ci-après :
— un support intermédiaire (1, 11, 21, 31), servant de substrat préliminaire, métallique, dont la forme résiste bien aux températures, est poli jusqu'à un brillant élevé sur son côté de revêtement, il est nettoyé et lavé puis séché,
— le support intermédiaire (1, 11, 21, 31) est imprimé en plusieurs étapes, en intercalant un début de séchage, selon le tracé inverse voulu, à l'aide des compositions résistantes, des compositions formatrices de pistes conductrices et des compositions formant les zones de raccordement,
— l'objet comportant ce tracé est soumis, pour le durcissement de la composition résistante, à un traitement de chauffage à une température élevée,
— l'objet comportant le côté revêtu est soumis, avec interposition d'une couche intermédiaire (6, 16, 26) à stratification sur un substrat (7, 17, 27, 37) servant de support permanent des circuits,
procédé caractérisé en ce que
— après le séchage du support intermédiaire (1, 11, 21, 31), on produit sur le côté de revêtement du support intermédiaire (1, 11, 21, 31) une couche d'oxyde de métal comme couche de séparation (2, 12, 22, 32), pouvant être enlevée par attaque chimique, cette production étant obtenue à partir du métal du support intermédiaire (1, 11, 21, 31) sous l'action de l'oxygène et de la température dans un four, et
— en ce que, après stratification sur le support permanent (7, 17, 27, 37) des circuits, on enlève le support intermédiaire (1, 11, 21, 31), par séparation et l'on enlève, par attaque chimique, la couche séparatrice (2, 12, 22, 32) du produit final.

2. Procédé selon la revendication 1, caractérisé en ce que le séchage du support intermédiaire (1, 11, 21, 31) est réalisé dans une installation à « Fréon ».

3. Procédé selon la revendication 1, caractérisé en ce que l'obtention de la couche séparatrice (2, 12, 22, 32) a lieu sous l'effet d'une température de 250 °C ± 10 °C en une demi-heure.

4. Procédé selon la revendication 1, caractérisé en ce que la composition résistante consiste en un liant organique dans lequel une matière de charge est dispersée.

5. Procédé selon la revendication 4, caractérisé en ce que le liant est une résine de mélamine/formaldéhyde et/ou une résine alkyde.

6. Procédé selon la revendication 4, caractérisé en ce que la matière de charge consiste en des particules de graphite et/ou de noir de carbone (ou noir de fumée) et/ou d'argent et/ou de nickel et/ou de particules réfractaires enrobées de carbone, dont la grosseur est inférieure à 5 $\mu$m.

7. Procédé selon la revendication 1, caractérisé en ce que le métal du support intermédiaire est constitué par du cuivre, de l'étain, du zinc, du fer, du chrome, du nickel et/ou de leurs alliages.

8. Procédé selon la revendication 1, caractérisé en ce que la couche intermédiaire consiste en une feuille (6) pré-imprégnée, produite à partir d'une nappe ou étoffe imprégnée d'une résine époxyde.

9. Procédé selon la revendication 1, caractérisé en ce que la stratification a lieu à une température de 100 °C à 200 °C, avantageusement à 120 °C, et sous une pression de 1 à 5 $N/mm^2$, avantageusement 1,5 $N/mm^2$, en un espace de temps compris entre 20 min et 3 h.

10. Procédé selon la revendication 1, caractérisé en ce que la couche intermédiaire (17, 27), consistant en une résine pour stratification, est appliquée sur le support intermédiaire (1, 11, 21, 31) revêtu ou sur le substrat (7, 17, 27, 37) ou sur les deux.

11. Procédé selon la revendication 10, caractérisé en ce que la résine pour stratification est une résine époxyde, phénolique, de polyester ou un de leurs mélanges.

12. Procédé selon la revendication 1, caractérisé en ce que le substrat est une matière isolante ou est une tôle de métal, électriquement isolée par la couche intermédiaire.

13. Procédé selon la revendication 1, caractérisé en ce que la couche intermédiaire, représentant simultanément le substrat (37), est produite dans un procédé de compression, de moulage par transfert ou par extrusion ou dans un procédé de moulage par injection.

14. Procédé selon la revendication 13, caractérisé en ce que le substrat (37) est une matière plastique thermodurcissable, avantageusement un polyphénol et/ou un polyester.

Fig. 1

**Fig. 2**

(a)

22        21

(b)

25  23  25          24          25  23  25

(c)

21

26          27

(d)

24

23    22    26    21    27    23

26          27

(e)

22          21

26          27

(f)

26    22    27

26          22          27

(g)

# Fig. 3

(a)

(b)

(c)

(d)

(e)

(f)

**Fig: 4**